# EUROPÄISCHE PATENTANMELDUNG

(11) **EP 2 234 199 A1**
(43) Veröffentlichungstag der Anmeldung: **29.09.2010**
(21) Anmeldenummer: 10003026.1
(22) Anmeldetag: 23.03.2010
(51) Int. Cl.: H01Q 1/12, H01Q 1/32

(54) **Antennenanordnung mit einer Spreizbefestigung**

(30) Priorität: 27.03.2009 DE 102009014669
(71) Anmelder: Hirschmann Car Communication GmbH, 72654 Neckartenzlingen (DE)
(72) Erfinder: Silva, David, 72622 Nürtigen (DE)
(74) Vertreter: Greif, Thomas

(57) **Zusammenfassung**

Die Erfindung betrifft eine Antennenanordnung eines Fahrzeuges, aufweisend eine Bodenplatte (1), wobei die Antennenanordnung Befestigungsmittel zur Befestigung auf einem Karosserieblech (5) des Fahrzeuges aufweist, wobei erfindungsgemäß vorgesehen ist, dass die Befestigungsmittel als ein durch eine Öffnung in der Bodenplatte (1) geführtes Spreizbefestigungselement (4) und einen damit zusammen wirkenden Spreizriegel (3) ausgebildet sind.

## Beschreibung

Die Erfindung betrifft eine Antennenanordnung eines Fahrzeuges sowie ein Verfahren zur Befestigung einer Antennenanordnung auf einem Karosserieblech eines Fahrzeuges gemäß den jeweiligen Merkmalen des Oberbegriffes der beiden unabhängigen Patentansprüche.

Antennenanordnungen, insbesondere Dachantennen, für Fahrzeuge, die eine Bodenplatte sowie Befestigungsmittel zur Befestigung der Antennenanordnung auf einem Karosserieblech des Fahrzeuges aufweisen, sind bekannt.

Bei einem bekannten Ausführungsbeispiel steht von der Bodenplatte aus Metall nach unten, das heißt, in Richtung des Karosseriebleches weisend, ein Gewindezapfen ab, wobei der Gewindezapfen durch eine Öffnung in dem Karosserieblech, insbesondere einem Fahrzeugdach, durchgesteckt, die Antennenanordnung ausgerichtet und anschließend auf den Gewindezapfen eine Befestigungsmutter aufgeschraubt wird. Diese Ausgestaltung der Antennenanordnung sowie das Verfahren zur Befestigung dieser Antennenanordnung auf dem Karosserieblech hat den Nachteil, dass zwei Montagepersonen erforderlich sind, wobei der eine Monteur die Antenne von oben auf dem Karosserieblech ausrichtet und festhält, während der zweite Monteur von unten, das heißt, aus dem Innenraum des Fahrzeuges, die Befestigungsmutter auf den durch das Karosserieblech ragenden Gewindezapfen aufschraubt.

Zur Verbesserung der Befestigungsverfahren sind schon andere Varianten bekannt geworden, wobei die Befestigungsmittel derart ausgestaltet sind, dass eine Person ausreicht, um die Antenne insbesondere von außen durch die Öffnung durchzuführen und durch eine Verschiebe- und Verdrehbewegung die Befestigungsmittel an dem Karosserieblech verrasten zu lassen. Damit ist es zwar möglich, dass eine Person alleine die Antennenanordnung auf dem Karosserieblech befestigt. Andererseits sind die bekannt gewordenen Befestigungsmittel aufwändig gestaltet, um zu gewährleisten, dass die Montage nur von einer Person durchgeführt werden kann.

Der Erfindung liegt daher die Aufgabe zu Grunde, die eingangs geschilderten Nachteile zu vermeiden, insbesondere soll die Antennenanordnung, genauer deren Befestigungsmittel, einfach gestaltet sein, und zum anderen soll das Verfahren einfach, schnell und zuverlässig nach wie vor von einer einzelnen Person durchgeführt werden können. Im Ergebnis wird dabei angestrebt, dass die Antennenanordnung dauerhaft und lagesicher auf dem Karosserieblech, insbesondere dem Fahrzeugdach, angeordnet und befestigt ist.

Diese Aufgabe wird durch die Merkmale der unabhängigen Patentansprüche gelöst.

Bei der erfindungsgemäßen Antennenanordnung ist vorgesehen, dass die Befestigungsmittel als ein durch eine Öffnung in der Bodenplatte geführtes Spreizbefestigungselement und einen damit zusammen wirkenden Spreizriegel ausgebildet sind. Diese Ausgestaltung hat den Vorteil, dass, nachdem die Antennenanordnung auf dem Karosserieblech angeordnet und ausgerichtet worden ist, eine erste, das heißt vorverrastende Lagefixierung der Antennenanordnung mittels des Spreizbefestigungselementes durchgeführt wird, wobei die endgültige Lagefixierung durch das mit dem Spreizbefestigungselement zusammen wirkenden Spreizriegel bewirkt wird. Der Spreizriegel bewirkt dabei in Zusammenwirken mit dem Spreizbefestigungselement, dass die Bodenplatte oder davon abstehende Auflagepunkte (die auch als Dichtung ausgebildet sein können) unter Vorspannung an sowie auf dem Karosserieblech zur Anlage kommt. Dabei bewirkt das Spreizbefestigungselement durch eine Vorverrastung die Lagefixierung der Bodenplatte der Antennenanordnung auf dem Karosserieblech, wobei die Vorspannung zur dauerhaften Lagefixierung der Bodenplatte auf dem Karosserieblech mittels des Spreizriegels, der von oben (das heißt, außerhalb des Fahrzeuges) oder unten (das heißt, innerhalb des Fahrzeuges) eingeführt und vorzugsweise verrastet werden kann, wobei dadurch das Spreizbefestigungselement von einer ersten Formgebung zu einer zweiten Formgebung bewegt wird, vorzugsweise gespreizt wird, um die dauerhafte Vorspannung und damit die dauerhafte Lagefixierung der Bodenplatte auf dem Karosserieblech zu bewirken.

In Weiterbildung der Erfindung ist beabstandet zu dem Spreizbefestigungselement ein in Wirkverbindung mit dem Karosserieblech bringbares Federelement angeordnet. Dieses Federelement bewirkt in vorteilhafter Weise, dass die Bodenplatte zusätzlich zu dem Spreizbefestigungselement unter Vorspannung in Bezug auf das Karosserieblech gehalten wird. Außerdem bewirkt das Federelement ergänzend oder alternativ eine erste, zwar noch nicht dauerhafte Lagefixierung, wobei aber auf Grund der Federkraft des Federelementes eine erste Lagefixierung und damit eine Ausrichtung der Antennenanordnung in Bezug auf ihre Soll-Position möglich ist.

In Weiterbildung der Erfindung ist an der Unterseite der Bodenplatte zumindest ein in Richtung des Karosserieblechs weisender Auflagepunkt vorgesehen. Dieser zumindest eine Auflagepunkt kann in allen Bereichen unterhalb der Bodenplatte, unter der sich keine Öffnung in dem Karosserieblech befindet, vorgesehen werden. In besonders vorteilhafter Weise sind drei Auflagepunkte in Form eines "Dreibeins" unterhalb der Bodenplatte angeordnet, wodurch eine besonders gute Standfestigkeit der Bodenplatte auf dem Karosserieblech gegeben ist, sowie Toleranzen bzw. Wölbungen in dem Karosserieblech ausgeglichen werden können.

In Weiterbildung der Erfindung weist das Spreizbefestigungselement zumindest einen sich an der Bodenplatte abstützenden Spreizarm und zumindest einen sich an dem Karosserieblech abstützenden Absatz auf. Durch diese Ausgestaltung des Spreizbefestigungselementes kann ebenfalls eine Lagefixierung der Antennenanordnung in ihrer Einbausituation erreicht werden, wobei der sich an der Bodenplatte zumindest eine abstützende Spreizarm durch den Spreizriegel aus seiner ursprünglichen Form heraus bewegt wird, um die für die dauerhafte Lagefixierung der Antennenanordnung auf dem Karosserieblech die erforderliche Andruckkraft (Vorspannung) der Bodenplatte auf das Karosserieblech aufzubringen.

Bei dem erfindungsgemäßen Verfahren zur Befestigung der die Bodenplatte aufweisenden Antennenanordnung ist vorgesehen, dass nach dem Aufsetzen der Antennenanordnung auf dem Karosserieblech ein Spreizbefestigungselement durch eine Öffnung in der Bodenplatte und eine (erste) Öffnung in dem Karosserieblech geführt und in seiner Endlage mittels eines Spreizriegels festgelegt wird. Das bedeutet, dass die Öffnung in der Bodenplatte in Deckung gebracht wird mit der Öffnung in dem Karosserieblech und anschließend das Spreizbefestigungselement durch diese beiden in Deckung gebrachten Öffnungen durchgeführt und in seiner Soll-Position festgelegt wird. Anschließend wird in das Spreizbefestigungselement der Spreizriegel eingeführt, der das Spreizbefestigungselement derart verformt, dass dadurch eine dauerhafte Befestigung der Bodenplatte auf dem Karosserieblech erzielt wird.

In Weiterbildung der Erfindung wird vor oder nach dem Aufsetzen der Antennenanordnung auf dem Karosserieblech die Antennenanordnung mittels eines Federelements auf dem Karosserieblech unter Vorspannung auf dem Karosserieblech angeordnet. Mit dem Federelement kann eine zusätzliche Lagefixierung und auch eine zusätzliche Vorspannung für die Bodenplatte bewirkt werden, so dass zunächst auf Grund der Festlegung der Bodenplatte mittels des Federelements an dem Karosserieblech eine temporäre Lagefixierung gegeben ist, so dass in diesem Zustand die Deckung der beiden Öffnungen in der Bodenplatte und in dem Karosserieblech gesucht werden kann, um nach Auffinden der Überdeckung der beiden Öffnungen das Spreizbefestigungselemente durch diese Öffnungen durchführen und somit einsetzen zu können.

In einer besonders vorteilhaften Ausgestaltung der Erfindung wird das Federelement durch eine weitere Öffnung des Karrosseriebleches geführt, wobei das Federelement durch eine in Bezug auf die Oberfläche des Karosseriebleches angestellte Führung (Schrägführung) das Karosserieblech am Rande der weiteren Öffnung hintergreift und anschließend die Bodenplatte mittels einer Schwenkbewegung auf das Karosserieblech aufgelegt und danach das Spreizbefestigungselement eingeführt und mittels des Spreizriegels festgelegt wird. Durch die schräge Führung der Bodenplatte in Bezug auf die Oberfläche des Karosserieblechs wird es ermöglicht, dass das entsprechend gestaltete Federelement durch eine Öffnung in dem Karosserieblech geführt und die Unterseite des Karosserieblechs hintergreifen kann, um eine erste Lagefixierung zu realisieren. In diesem angestellten Zustand (Schrägstellung der Bodenplatte in Bezug auf das Karosserieblech) kann von der Montageperson die Überdeckung der beiden Öffnungen in dem Karosserieblech und der Bodenplatte gesucht werden, und bei Auffinden der Überdeckung der beiden Öffnungen die Bodenplatte auf das Karosserieblech abgesenkt werden (vorzugsweise parallele Ausrichtung der ebenen Bodenplatte in Bezug auf die ebene Karosserieblechoberfläche), wobei danach das Spreizbefestigungselement eingeführt und mittels des Spreizriegels festgelegt werden kann.

Weitere konstruktive Ausgestaltungen der Antennenanordnung sowie eine weitere ergänzende Beschreibung des Befestigungsverfahrens der Antennenanordnung auf dem Karosserieblech sind im Folgenden in Zusammenhang mit den Figuren beschrieben und näher erläutert.

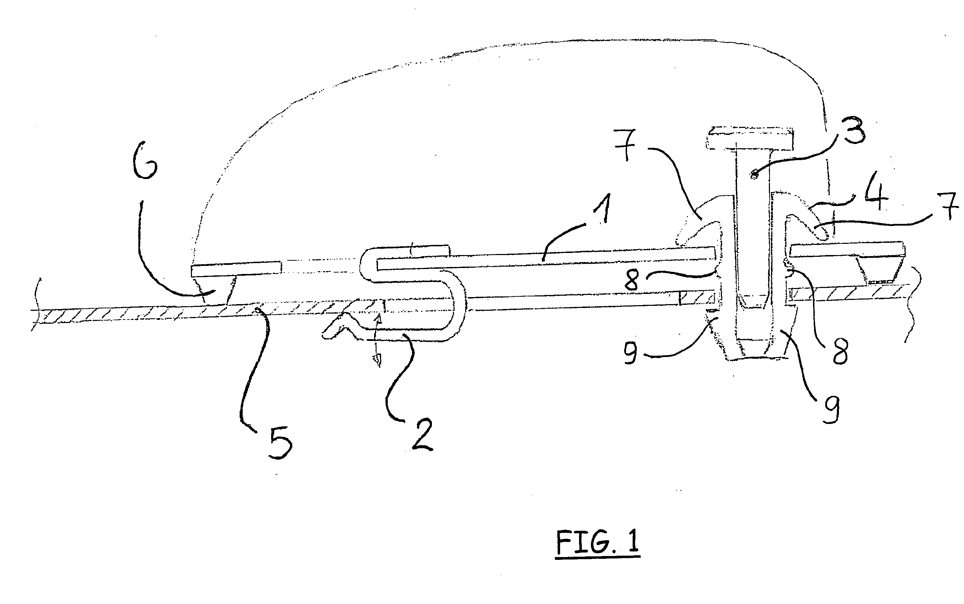

In Figur 1 ist, soweit im Einzelnen dargestellt, mit der Bezugsziffer 1 eine Bodenplatte einer Antennenanordnung bezeichnet. Diese Bodenplatte 1 nimmt Antennenelemente (hier nicht dargestellt) auf, wobei diese von einer ebenfalls nicht dargestellten Abdeckhaube zwecks Schutz vor äußeren Witterungseinflüssen abgedeckt sind. ein Federelement 2 aus Metall oder Kunststoff ist an der Bodenplatte 1 befestigt, vorzugsweise weist es mit seinem ersten U-förmigen Schenkel durch eine Öffnung und umklammert die Bodenplatte 1 im Randbereich dieser Öffnung. Von diesem U-förmigen Schenkel steht in entgegengesetzter Richtung ein weiterer U-förmiger Schenkel ab, so dass das Federelement 2 in vorteilhafter Weise einen S-förmigen Querschnitt aufweist, wobei dessen Funktion später noch erläutert wird. Weiterhin ist ein Spreizriegel 3 vorhanden, der mit einem Spreizbefestigungselement 4 in Wirkverbindung bringbar ist.

In Figur 1 ist die Bodenplatte 1 schon in ihrer Soll-Position auf einem Karosserieblech 5, insbesondere einem Fahrzeugdach, angeordnet worden. Bei dieser Variante sind in dem Karosserieblech 5 zwei Öffnungen vorgesehen. Durch die erste, vorzugsweise kleinere (bei Betrachtung der Figur 1 rechte) Öffnung wird das Spreizbefestigungselement 4 durchgeführt. Dabei kann das Spreizbefestigungselement 4 ebenfalls durch eine Öffnung in der Bodenplatte 1 durchgeführt werden, wenn die beiden Öffnungen sowohl in der Bodenplatte 1 als auch in dem Karosserieblech 5 in Überdeckung gebracht worden sind. Dies erfolgt dann, wenn die Bodenplatte 1 mittels des Federelements 2, dessen zweiter Schenkel die Unterseite des Karosserieblechs 5 hintergreift, in ihrer Lage vorfixiert worden ist. Das bedeutet bei Betrachtung der Figur 1, dass die Bodenplatte 1, vorzugsweise über Auflagepunkte 6, auf das Karosserieblech 5 aufgesetzt worden ist. Auf Grund einer Linearverschiebung der Bodenplatte 1 in Bezug auf das Karosserieblech 5 kann das an der Bodenplatte 1 befestigte Federelement 2 durch die (vorzugsweise größere) Öffnung in dem Karosserieblech 5 geführt und mit dem Ende des zweiten Schenkels, der abgewinkelt sein kann, die Unterseite des Karosserieblechs 5 hintergreifen. Dadurch wird durch das Federelement 2 eine Vorspannung auf die Bodenplatte 1 ausgeübt, so dass diese in Bezug auf das Karosserieblech 5 vorfixiert ist. Danach wird gegebenenfalls durch eine weitere Linearbewegung oder sonstige Verschiebung der Bodenplatte 1 in Bezug auf das Karosserieblech 5 von dem Monteur die Überdeckung der Öffnung in der Bodenplatte 1 und in dem Karosserieblech 5 gesucht. Nach Auffinden der Überdeckung kann das Spreizbefestigungselement 4 durch diese beiden in Überdeckung gebrachten Öffnungen durchgeführt, verrastet und mittels des Spreizriegels 3 derart verformt werden, dass dadurch die Bodenplatte 1 dauerhaft auf dem Karosserieblech 5 in ihrer Lage fixiert ist.

Alternativ dazu ist es denkbar, dass das Spreizbefestigungselement 4 schon an der Bodenplatte 1 insbesondere rastend angeordnet und befestigt ist. Hierzu weist es zumindest einen Spreizarm 7 auf, der sich an der einen Oberfläche der Bodenplatte 1 abstützt. Zur Verrastung des Spreizbefestigungselements 4 an der Bodenplatte 1 ist weiterhin ein Wulst 8 vorgesehen, der sich an der Unterseite der Bodenplatte 1 abstützt. Somit ist das Spreizbefestigungselement 4 durch den zumindest einen Spreizarm 7 (der auch eine Vorspannung aufbringen kann) und den Wulst 8 rastend an der Bodenplatte 1 befestigt. In dieser Konstellation kann durch eine angestellte Führung der Bodenplatte 1 in Bezug auf das Karosserieblech zunächst durch eine schräge Führung in Verbindung mit einer axialen Verschiebung das eine Ende des Federelementes 2 (das Ende mit der vorzugsweise in der Figur 1 dargestellten Abwinklung) die Unterseite des Karosseriebleches 5 hintergreifen, wobei durch eine Absenkung der Bodenplatte 1 die Auflagepunkte 6 auf dem Karosserieblech 5 zur Anlage kommen, wobei das Spreizbefestigungselement 4 mit seinem freien, das heißt, von der Bodenplatte 1 wegweisenden Ende, durch die vorzugsweise kleinere Öffnung in dem Karosserieblech 5 durchgeführt wird. In vorteilhafter Weise weist dabei dieses freie Ende des Spreizbefestigungselementes 4 einen Absatz 9 auf, dessen geometrische Erstreckung so gewählt ist, dass er größer ist als die Öffnung in dem Karosserieblech, jedoch nach Durchführung durch diese Öffnung die Unterseite des Karosseriebleches 5 dauerhaft und zuverlässig hintergreift. Das bedeutet, dass der Absatz 8 in einer runden Ausgestaltung im Durchmesser größer ist als der Durchmesser der Öffnung in dem Karosserieblech 5. Nachdem die Bodenplatte 1 in der in Figur 1 dargestellten Lage auf dem Karosserieblech 5 fixiert worden ist, wird der Spreizriegel 3 in das Spreizbefestigungselement 4 in diesem Fall von oben eingesetzt. Dabei ist der Spreizriegel 3 so ausgestaltet, dass er rastend in eine Endlage in das Spreizbefestigungselement 4 eingesetzt werden kann, wobei er dann den zumindest einen Spreizarm 7 dauerhaft verformt ("zusammendrückt"), so dass die Bodenplatte 1 unter Vorspannung, auch unter Berücksichtigung der Vorspannung des Federelements 2, an dem Karosserieblech 5 gehalten wird. In diesem Ausführungsbeispiel ist es möglich, den Spreizriegel 3 von oben, das heißt, von außerhalb des Fahrzeuges, in das Spreizbefestigungselement 4 einzusetzen, da die Antennenanordnung noch nicht mit der Abdeckhaube versehen worden ist.

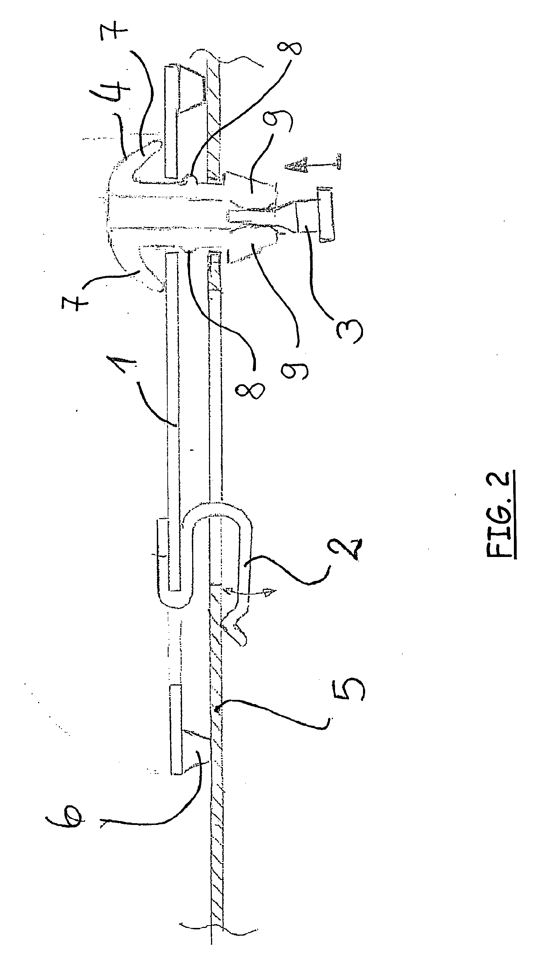

Sollte ein Zugang des Spreizbefestigungselements 4 von oben nicht möglich sein, kann also Alternative daran gedacht werden, den Spreizriegel 3 von unten, das heißt, von einem Fahrzeuginnenraum (wie Fahrgastzelle, Kofferraum oder dergleichen) in das Spreizbefestigungselement 4 einzusetzen. Diese Einbausituation ist in Figur 2 dargestellt. Für die Ausführungsbeispiele der beiden Figuren 1 und 2 gilt noch Folgendes: Das Spreizbefestigungselement 4 kann ergänzend oder alternativ zu der Verformung der Spreizarme 7 durch den Spreizriegel 3 auch so ausgebildet sein, dass mittels des Spreizriegels 3 der freie, untere Endbereich im Bereich des Absatzes 9 durch den Spreizriegel 3 verformt wird. In diesem Fall kann daran gedacht werden, dass das Spreizbefestigungselement 4 zumindest teilweise einen Längsschlitz aufweist, mit dem es ermöglicht wird, dass das untere freie Ende im Bereich des Absatzes 9 durch den Spreizriegel 3 aufgespreizt wird, um die Bodenplatte 1 unter Vorspannung an dem Karosserieblech 5 in ihrer Soll-Position dauerhaft festzusetzen. Der Spreizriegel 3 sowie das Spreizbefestigungselement 4 bestehen bevorzugt aus Kunststoff, und werden in einem Kunststoff-Spritzgussverfahren hergestellt, wodurch sich kostengünstig auch in größeren Stückzahlen die gewünschte Formgebung und Funktion realisieren lässt.

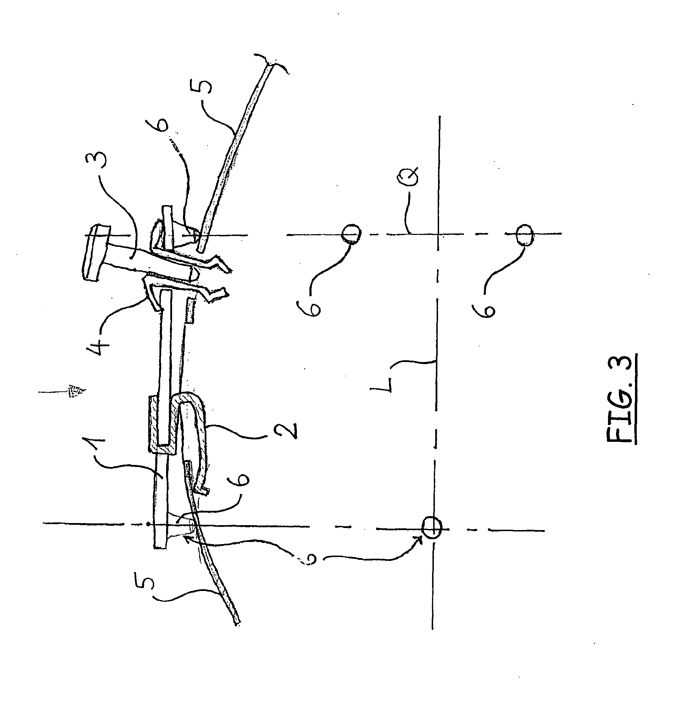

In der Figur 3 ist, soweit im Einzelnen dargestellt, ausschnittsweise wieder eine an sich bekannte Antennenanordnung dargestellt. Zu der Antennenanordnung zugehörig sind Antennenelemente sowie eine Abdeckhaube der Antennenelemente, wobei diese Bauteile der Antennenanordnung vorhanden sind, aber nicht dargestellt sind.

In Bezug auf einen Aspekt der Erfindung ist wichtig, dass von der Unterseite der Bodenplatte vorzugsweise genau drei Auflagepunkte 6 abstehen, über diese drei Auflagepunkte 6 stützt sich die Bodenplatte 1 auf der Oberfläche des Karosseriebleches 5 ab, wobei sie ansonsten auf Distanz zu diesem angeordnet ist. Dadurch ist es möglich, wie in der Figur 3 ersichtlich, Wölbungen oder dergleichen des Karosseriebleches 5 bei gleichzeitig flächiger und ebener Gestaltung der Bodenplatte 1 auszugleichen. Von besonderem Vorteil ist die Anordnung der Auflagepunkte 6, wie sie der unteren Darstellung der Figur 3 entnommen werden kann. Dabei liegt der eine Auflagepunkt 6 (bei Betrachtung der Figur 1 der linke Auflagepunkt 6) auf einer Längsachse L und die beiden anderen Auflagepunkte 6 (bei Betrachtung der Figur die beiden rechten Auflagepunkte 6) auf einer Querachse Q, wobei zur bestmöglichen Abstützung die beiden auf der Querachse Q liegenden Auflagepunkte 6 äquidistant zu der Längsachse L angeordnet sind.

Um ein Eindringen von Wasser, Feuchtigkeit, Schmutzpartikeln oder dergleichen durch die zumindest eine Öffnung in dem Karosserieblech 5 in den Innenraum des Fahrzeuges zu verhindern (was mit der Ausgestaltung der vorzugsweise punktförmigen Auflagepunkten 6 nicht möglich wäre), kann daran gedacht werden, an dem äußeren, umlaufenden Rand der Bodenplatte 1 eine derart elastisch verformbare Dichtung anzuordnen, die einen derartigen Verformungsbereich hat, dass unter Beibehaltung der flächigen und ebenen Gestaltung der Bodenplatte 1 die Formgebung, insbesondere die Wölbung, des Karosseriebleches 5 ausgeglichen wird. In einem solchen Fall würde eine solche Dichtung also in bestimmten Bereichen mehr und in anderen bestimmten Bereichen weniger zusammengedrückt, um insgesamt unter Vorspannung stehend die zumindest eine Öffnung in dem Karosserieblech vor äußeren Einflüssen abzudichten. Alternativ oder ergänzend dazu kann daran gedacht werden, die Abdeckhaube dem gewünschten Einbauort, insbesondere der vorgesehenen Einbaufläche, in ihrer unteren umlaufenden Randgestaltung anzupassen, wobei dieser Bereich alternativ oder ergänzend zu der schon vorbeschriebenen Dichtung ebenfalls mit einer Dichtung versehen werden kann. Besteht die Bodenplatte und/oder die Abdeckhaube aus Kunststoff, kann daran gedacht werden, den äußeren, umlaufenden Rand der Bodenplatte und/oder den unteren, umlaufenden Rand der Abdeckhaube mit einer in Richtung der Oberfläche des Karosseriebleches 5 weisenden Dichtung in einem Zweikomponenten-Kunststoff-Spritzgussverfahren zu versehen.

### Bezugszeichenliste

1. Bodenplatte
2. Federelement
3. Spreizriegel
4. Spreizbefestigung (Spreizbefestigungselement)
5. Karosserieblech
6. Auflagepunkt
7. Spreizarm
8. Wulst
9. Absatz

L: Längsachse
Q: Querachse

## Patentansprüche

1. Antennenanordnung eines Fahrzeuges, aufweisend eine Bodenplatte (1), wobei die Antennenanordnung Befestigungsmittel zur Befestigung auf einem Karosserieblech (5) des Fahrzeuges aufweist, **dadurch gekennzeichnet, dass** die Befestigungsmittel als ein durch eine Öffnung in der Bodenplatte (1) geführtes Spreizbefestigungselement (4) und einen damit zusammen wirkenden Spreizriegel (3) ausgebildet sind.

2. Antennenanordnung nach Anspruch 1, **dadurch gekennzeichnet, dass** beabstandet zu dem Spreizbefestigungselement (4) ein in Wirkverbindung mit dem Karosserieblech (5) bringbares Federelement (2) angeordnet ist.

3. Antennenanordnung nach Anspruch 1 oder 2, **dadurch gekennzeichnet, dass** ein an der Unterseite der Bodenplatte (1) zumindest ein in Richtung des Karosserieblechs (5) weisender Auflagepunkt (6) vorgesehen ist.

4. Antennenanordnung nach einem der Ansprüche 1 bis 3, **dadurch gekennzeichnet, dass** das Spreizbefestigungselement (4) zumindest einen sich an der Bodenplatte (1) abstützenden Spreizarm (7) und zumindest einen sich an dem Karosserieblech (5) abstützenden Absatz (9) aufweist.

5. Antennenanordnung nach einem der vorhergehenden Ansprüche, **dadurch gekennzeichnet, dass** der Spreizriegel (3) und/oder das Spreizbefestigungselement (4) als Kunststoffbauteile ausgebildet sind.

6. Verfahren zur Befestigung einer eine Bodenplatte (1) aufweisenden Antennenanordnung auf einem Karosserieblech (5) eines Fahrzeuges, wobei die Antennenanordnung an der Einbauposition auf dem Karosserieblech (5) angeordnet wird und anschließend Befestigungsmittel zur endgültigen Befestigung der Antennenanordnung auf dem Karosserieblech (5) betätigt werden, **dadurch gekennzeichnet, dass** nach dem Aufsetzen der Antennenanordnung auf dem Karosserieblech (5) ein Spreizbefestigungselement (4) durch eine Öffnung in der Bodenplatte (1) und dem Karosserieblech (5) geführt und in seiner Endlage mittels eines Spreizriegels (3) festgelegt wird.

7. Verfahren nach Anspruch 6, **dadurch gekennzeichnet, dass** vor oder nach dem Aufsetzen der Antennenanordnung auf dem Karosserieblech (5) die Antennenanordnung mittels eines Federelementes (2) auf dem Karosserieblech (5) unter Vorspannung auf dem Karosserieblech (5) angeordnet wird.

8. Verfahren nach Anspruch 6, **dadurch gekennzeichnet, dass** das Federelement (2) durch eine weitere Öffnung in dem Karosserieblech (5) geführt wird, wobei das Federelement (2) durch eine in Bezug auf die Oberfläche des Karosseriebleches (5) angestellte Führung das Karosserieblech (5) am Rande der Öffnung hintergreift, wobei anschließend die Bodenplatte (1) durch eine Schwenkbewegung auf das Karosserieblech (5) aufgelegt wird und danach das Spreizbefestigungselement (4) durch die erste Öffnung in dem Karosserieblech (5) eingeführt und mittels des Spreizriegels (3) festgelegt wird.

9. Verfahren nach einem der Ansprüche 6 bis 8, **dadurch gekennzeichnet, dass** Spreizbefestigungselement (4) dann durch die Öffnung in der Bodenplatte (1) und durch die erste Öffnung in dem Karosserieblech (5) eingeführt wird, wenn diese beiden Öffnungen in Überdeckung gebracht worden sind.

10. Verfahren nach einem der Ansprüche 6 bis 8, **dadurch gekennzeichnet, dass** das Spreizbefestigungselement (4) an der Bodenplatte (1) befestigt ist und durch die erste Öffnung in dem Karosserieblech (5) durchgeführt wird.
